(19) Europäisches Patentamt
European Patent Office
Office européen des brevets

(11) Publication number: **0 087 426**
**B1**

(12) # EUROPEAN PATENT SPECIFICATION

(45) Date of publication of patent specification: **26.07.89**

(51) Int. Cl.$^4$: **C 30 B 13/06**

(21) Application number: **82901665.8**

(22) Date of filing: **14.04.82**

(86) International application number:
**PCT/US82/00465**

(87) International publication number:
**WO 82/03639 28.10.82 Gazette 82/26**

(54) **LATERAL EPITAXIAL GROWTH BY SEEDED SOLIDIFICATION.**

(30) Priority: **16.04.81 US 254871**
**18.03.82 US 359284**

(43) Date of publication of application:
**07.09.83 Bulletin 83/36**

(45) Publication of the grant of the patent:
**26.07.89 Bulletin 89/30**

(84) Designated Contracting States:
**DE FR GB**

(56) References cited:
**US-A-3 585 088**
**US-A-4 174 422**

**APPLIED PHYSICS LETTERS, vol. 37, no. 6, September 16, 1980, pages 560-562, New York, US; R.W. McCLELLAND et al.: "A technique for producing epitaxial films on reuseable substrates"**

**APPL. PHYS. LETT., issued 01 September 1980, Geiss et al., Silicon graphoepitaxy using a strip-heater oven, pp. 454-456**

(73) Proprietor: **MASSACHUSETTS INSTITUTE OF TECHNOLOGY**
**77 Massachusetts Avenue**
**Cambridge, MA 02139 (US)**

(72) Inventor: **TSAUR, Bor-Yeu**
**17 Brattle Street Apartment No 1**
**Arlington, MA 02174 (US)**
Inventor: **FAN, John C. C.**
**239 South Street**
**Chestnut Hill, MA 02167 (US)**
Inventor: **GEIS, Michael W.**
**8 Tuttle Drive**
**Acton, MA 01720 (US)**

(74) Representative: **Holdcroft, James Gerald, Dr. et al**
**Graham Watt & Co. Riverhead**
**Sevenoaks Kent TN13 2BN (GB)**

**EP 0 087 426 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Technical field

This invention is in the field of materials, and more particularly relates to the conversion of amorphous or polycrystalline materials, such as sheets of semiconductor material, to sheets of substantially single-crystal semiconductor material.

Background art

Much of modern technology makes use of thin solid films on the surfaces of solid substrates. A number of methods have been used to deposit such thin films including thermal evaporation, DC sputtering, rf sputtering, ion beam deposition, chemical vapor deposition, plating, molecular beam deposition and deposition from the liquid phase.

The structure of thin films can be amorphous (that is, the atoms of the film are not arranged in any crystalline order), polycrystalline (that is, the film is composed of many small regions, in each of which the atoms are arranged in a regular crystalline order, but the small regions have no mutual alignment of their crystallographic axes), preferred orientation (that is, the film is composed of many small regions, in each of which the atoms are arranged in a regular crystalline order, and one or more of the crystalline axes of the majority of said regions are parallel), or epitaxial (that is, the film is predominantly of a single crystallographic orientation). An epitaxial or single crystal film is a special case of a preferred orientation film in which corresponding crystallographic axes of all the small regions are essentially oriented in the same directions. A thin film can be the same material (that is, the same element or compound) as the substrate, or it can differ in chemical composition from the substrate. If the film is epitaxial, the former is called "homoepitaxy" and the latter "herteroepitaxy".

In many solid state electronic devices, the active volume of the device comprises or lies within a thin sheet, film or layer of crystalline semiconductor material, preferably in the single crystal or monocrystalline form. This active volume is formed on an insulative substrate. This is particularly true of integrated circuits formed from semiconductors such as gallium arsenide, silicon, germanium, indium phosphide, cadmium telluride, etc. Present techniques for fabricating such devices, however, require that the crystalline sheets or films be grown mainly by chemical vapor deposition from the surface of relatively thick substrates of high-purity, single crystal semiconductor material, such as sapphire the use of such substrates for each sheet produced tends to inordinately increase the cost of producing the thin sheets. Furthermore, the high defect density of the epitaxial sheets or films thus formed and the high dielectric constant of the sapphire limits the performance of the resulting device.

Another alternative has been to form large grain sheets or films using a scanned laser beam to heat an amorphous or polycrystalline sheet or film of semiconductor material, such as Si, which has been deposited on sapphire or fused silica ($SiO_2$). See, for example, U.S. Patent 4,059,461. Small grains, less than 50 µm in size, are obtained by this process and the film when overlayed on $SiO_2$ has a tendency to crack. When processed on sapphire, the Si film may interact detrimentally with the sapphire.

Another recent innovation in the growth of epitaxial films is described in a paper entitled "Silicon Graphoepitaxy Using a Strip-Heater Oven" by M. W. Geis, D. A. Antoniadis, D. J. Silversmith, R. W. Mountain and Henry I. Smith *Appl. Phys. Lett.* *37*(5) 1 September 1980 which relates to the conversion of amorphous silicon to a silicon mosaic film by graphoepitaxy with a film or "cap" of $SiO_2$ over the silicon film.

The graphoepitaxy process requires the intentional creation of artificial surface relief steps or point defects in a geometric pattern on a substrate to control in a predetermined way the process of film formation and growth on the substrate. The geometric pattern is generally a simple grating or grid, oriented to promote crystal growth in a predetermined manner.

In the graphoepitaxy process, the substrate crystal orientation plays a passive role in the formation of the crystal orientation and growth which is determined primarily by the surface relief structure.

As reported on page 455 of the referenced *Appl. Phys. Lett.* even with a "cap", if the silicon film is fully melted in a graphoepitaxial process, neither texture or orientation of the crystallized film is observed. Apparently, the function of the $SiO_2$ cap in the graphoepitaxy process is to produce a shear stress as a result of thermal expansion differences between Si and $SiO_2$ which leads to anisotropy in the Si such that upon crystallization a (100) texture and uniform orientation relative to the relief gratings occurs.

Also, recently, there has been devised a method of achieving lateral epitaxial growth by seeded solidification (melting and refreezing of amorphous Si) through openings in an insulator formed on a crystallization substrate (WO 81/02948). After the growth is discontinued, the sheet of crystalline material is cleaved or otherwise separated from its substrate which may optionally be reused. This process we shall refer to for the sake of convenience as the CLEFT process.

While the CLEFT process is believed to represent a significant advance over the state-of-the-art at the time the invention was made; certain problems have arisen in the application of the CLEFT process to the consistent production of high quality, defect free, epitaxial films. More specifically, if for any reason, the lateral epitaxial growth is discontinuous, then further epitaxial growth is precluded since the further growth has no crystalline orientation to start from and will therefore grow in random polycrystalline fashion. Accordingly, a need exists for a method and apparatus for minimizing discontinuities in epitaxial films laterally grown through openings in an insulative mask formed on a crystallization substrate.

We have also found that where lateral growths meet, i.e., when lateral growth in one direction encounters lateral growth from another direction, dislocation defects are apt to occur; presumably caused by the strain or stress created when two crystallization fronts meet.

For these and other reasons, it would be highly desirable to have a process for producing lateral epitaxial growth in amorphous semiconductor material wherein discontinuities in growth and crystal dislocations are minimized and which is relatively simple in operation and low in cost.

According to the present invention, there is provided a method of forming a layered semiconductor structure on a substrate body having at least one region of single crystal material covered by an intermediate insulating layer, the method being characterised by the steps comprising:

forming a layer of amorphous or polycrystalline semiconductor material over said substrate body but separated from the said region by the intermediate layer;

after forming the semiconductor material layer, providing at least one opening in the insulating layer for exposing the semiconductor material layer to the single crystal material;

depositing another layer over the semiconductor and insulating layers, the other layer being a material operative as a wetting agent to counteract a tendency of the semiconductor material to form beads when melted;

heating, e.g. by radiant energy, at least a portion of the semiconductor layer near said opening to melt this portion and establish a mass flow of the melted portion to said region of single crystal material and thereby establish orientation contact between the semiconductor layer and the said region; and

solidifying the melted portion of the semiconductor layer adjacent said opening to recrystallize it into large grain, substantially single crystal material seeded by the said region.

Also according to the present invention, there is provided a method of forming a semiconductor body, wherein amorphous or polycrystalline semiconductor material in contact with an insulating layer is transformed to large grain, substantially single crystal semiconductor material, characterised in that:

an external seeding means is employed in operative contact with the semiconductor material to be transformed,

a layer of the amorphous or polycrystalline semiconductor material is formed over the insulating layer,

a layer of a wetting agent material is formed over the insulating and semiconductor layers to prevent agglomeration of the semiconductor material when melted;

thereafter at least a portion of the semiconductor layer is heated to melt the portion thereof and establish an orientation contact of the melted portion with the seeding means; and

the melted portion of the semiconductor layer is solidified and transformed to create large grain, substantially single crystal material, which transformed material has a crystal orientation predetermined by the crystal orientation of the seeding means.

In practising the present invention, transformation of amorphous or polycrystalline semiconductor material to epitaxial material is achieved using a layer of wetting agent material which preferably has a melting point higher than the crystallization temperature of the material being transformed.

This wetting agent layer is disposed in contact with the semiconductor material to be transformed. The semiconductor material is also in contact and/or adjacent with a single crystal seed material. By "wetting agent" is meant a substance or composition that causes the spreading of the semiconductor material out and over an underlying or overlying intimately contacting surface. While the precise nature of the phenomena associated with this wetting agent layer is not entirely understood, at present, we are of the opinion that this layer serves to prevent the semiconductor material from agglomerating (beading or balling up) as the crystalline front propagates laterally during epitaxial growth.

Agglomeration or "balling up" of the semiconductor material during the growth process is to be avoided since it results in voids or discontinuities in the film or layer. Once a void occurs, epitaxial growth; which is predicated on continuity with the seed, is interrupted.

It should be emphasized that the function of the wetting agent layer is fundamentally different and distinct from the "cap" referenced in the prior art graphoepitaxy process. The primary purpose of the wetting agent layer is to wet the surfaces between the material to be crystallized and the seed material. The seed material is the principle determinant of the resultant crystalline properties. On the other hand, the graphoepitaxy "cap" is intended, not as a "wetting agent", but to actively contribute to the crystalline orientation and textural properties of the grown material.

In one embodiment of the invention, the growth is achieved from a seed which is not a part of the substrate as in the aforementioned CLEFT process. A "seed" is a body of single-crystal semiconductor material from which the epitaxial growth originates. However, unlike the embedded or buried single crystal material in the CLEFT process, an externally seeded growth is achieved from a body of single-crystal growth material which is provided on an external face or surface of the amorphous material which is being transformed to single-crystal material. In the external seed embodiment it is unnecessary to make openings in insulative layers to reach the underlying single crystal seed material.

Furthermore, growth can be achieved by starting at the external seed and propagating the crystallization front in one direction along the surface of the amorphous material. In this and other embodiments to be described, the crystallization front does not encounter a crystallization front propagating from the opposite direction, as in the case of parallel adjacent stripe openings, and potential crystal dislocations caused by such an encounter are avoided.

Brief description of the drawings

Fig. 1 is a process flow diagram for one embodiment of a process according to this invention;

Fig. 2 presents a series of schematic views illustrating a first embodiment of the invention according to the process shown in Fig. 1;

Fig. 3 presents a schematic illustrating a prior art structure made without a wetting agent layer;

Fig. 4 presents a schematic perspective view illustrating a technique of this invention, in simplified form, a stationary single heater embodiment for thermally heating a sample to produce lateral epitaxial growth from a crystallization substrate;

Fig. 4a is a plot which shows the thermal profile to which the sample in Fig. 4 is subjected;

Fig. 4b is a schematicized cross-section of a portion of the sample in Fig. 4;

Fig. 5 is a perspective of a dual heater embodiment of the invention;

Fig. 6 is an exploded perspective showing the apparatus of Fig. 5 in more detail;

Fig. 7 is a perspective as in Fig. 6 except that the heater is located parallel to the stripe opening;

Fig. 8 is a schematic perspective view of an external seed embodiment which is suitable for growing sheets which are substantially single crystal;

Fig. 9 is a schematic perspective view of an external seed embodiment with an overlayer of $SiO_2$.

Fig. 10 is a schematic perspective view of an external seed embodiment with both the $SiO_2$ wetting agent layer and Si layer over the seed;

Fig. 11 is a schematic perspective view of a composite wetting agent embodiment;

Fig. 11a is a schematic perspective view of an embodiment in which the wetting agent is located on the mask surface.

Fig. 12 is a series of schematic perspective views illustrating the steps in forming a planar embodiment of the invention.

Figs. 13A and 13B show the construction in partial schematic form of a three terminal semiconductor device fabricated on a $SiO_2$ substrate manufactured in accordance with the process described herein.

Fig. 14 is a process flow diagram of an alternate embodiment of a process in accordance with the invention.

Fig. 15 is a perspective view of a further embodiment of the invention utilizing a simplified scribing technique to induce seeded solidification.

Fig. 16 is an enlarged partial cross-sectional view of Fig. 15 taken along lines 16—16.

Best mode of carrying out the invention

The following description generally relates to silicon semiconductor epitaxial growth and silicon is selected since silicon is the most important semiconductor material in use today. However, the invention is in no way intended to be limited thereby. In fact, the invention will have beneficial application in the epitaxial growth of other well known semiconductor material such as gallium arsenide and germanium to name a few.

A variety of specific embodiments of this invention will now be illustrated with reference to the Figures. In these Figures, like elements have been given like numerals.

Figure 1 is a process flow sheet presenting the steps for one embodiment of this invention. In the first step of this process, a crystal growth mask is formed on a crystallization substrate to cover portions of the substrate and to leave a pattern of exposed substrate areas. The crystallization substrate can be a single crystal substrate, such as a single crystal of silicon, germanium, gallium arsenide or other semiconductor, or any other substrate capable of supporting crystal growth on at least some exposed area of the surface. The growth mask is formed from a material which will inhibit nucleation on the growth mask itself but will permit crystalline growth laterally from exposed areas.

In the next step of this embodiment, amorphous or polycrystalline semiconductor material is deposited over the mask and exposed areas of the substrate. This might be done, for example, by placing the masked substrate in a chemical vapor deposition reactor.

After the first layer of amorphous semiconductor material has been formed, a second layer is formed of a suitable wetting agent material. This second layer should preferably have a higher melting temperature than the first layer. For example, if the first layer is amorphous silicon, the second layer may comprise $SiO_2$. The respective melting points of these materials are $Si \cong 1430°C$ and for $SiO_2 \cong 1700°C$.

Next, the structure is subjected to a heating cycle by any of several methods to be described in detail later whereby the first layer is caused to melt and then solidify. As it solidifies, single crystal growth is initiated at areas exposed by the mask and lateral epitaxial overgrowth occurs.

Figure 2 presents a series of views which schematically illustrate the production of a continuous thin sheet of mono-crystalline material on a crystallization substrate according to the process of Figure 1.

In Figure 2A, relatively thick crystallization substrate 10 is shown. This substrate can be any material capable of supporting crystal growth thereon. As a typical example of a substrate suitable for growing single crystal silicon thereon, substrate 10 might be a slab of single crystal Si in the range of 0.13—1.3 mm (5—50 mils) thick and might be doped or undoped. If the crystalline film produced is to be separated by cleavage, it is preferred, although not essential, that substrate 10 have an orientation so that the surface of substrate 10 lies in a plane which is a preferential cleavage plane for the substrate material.

As shown in Figure 2B, crystal growth mask 12 is then applied to substrate 10. Mask 12 has a pattern of openings through which substrate 10 is exposed. One typical pattern found to be suitable is a pattern of slits or stripes 14 as shown in Figure 2B. The ratio of width to spacing for slits 14 can be widely varied depending upon the materials, growth conditions, required layer thickness, separation techniques employed, etc., and the optimum ratio, which depends on the particular application, can be determined by methods described in detail in the CLEFT application. Of course, growth masks having patterns of exposed areas other than slits can also be employed.

Next, as shown in Figure 2C, a layer 18 of amorphous or polycrystalline semiconductor material, such as Si, is formed over the mask and extending into the stripes 14, as shown at 16 to contact the exposed single-crystal substrate 10. This layer may be formed by well known means such as by chemical vapor deposition.

Finally, as shown in Figure 2D, a second layer 20 of $SiO_2$, for example, is formed, such as by chemical vapor deposition or thermal oxidation, over the first amorphous Si layer. The structure shown in Figure 2D is then subjected to a heat treatment as will be described in detail, which melts the silicon layer 18. The layer 18 then solidifies and single crystal growth is initiated from the interface 16 with the epitaxial substrate 10. In other words, epitaxial growth is "seeded" by substrate 10. This growth proceeds laterally from the interfaces 16 until the lateral growths meet to form a continuous layer.

The function of the second layer 20 may be appreciated after a consideration of Figure 3 which shows in simplified form the problems encountered with the prior art CLEFT process. In the CLEFT process, no second layer 20 is used, thus when the amorphous silicon layer 18' is melted, the layer tends to agglomerate or "ball-up" as shown in schematic form in Figure 3. In some cases, discontinuities are created between "balls" of material creating islands at 19 of amorphous or polycrystalline material resulting from the interruption of the seeded epitaxial growth from substrate 10. The initial growth at 21 is satisfactory since here the interface is between compatible surface structure, Si to Si, so no agglomeration occurs.

With the addition of a wetting agent layer 20 over layer 18, as in Figure 2, such tendency to agglomerate has been minimized and substantially defect free lateral epitaxial growth has been repeatedly achieved. Depending on the selection of thermal treatment and other parameters, lateral growths in excess of 1 cm have been achieved and further extension is expected.

Apparatus for subjecting the sample prepared in accordance with the invention to an appropriate heat cycle will now be described in connection with Figure 4.

In the apparatus of Figure 4, a 1×2 cm sample 34, an exploded section of which is shown schematically in Figure 4b, cut from a wafer prepared in accordance with Figure 2A—D having the following constituents and dimensions; is placed on a graphite cloth strip heater 30, with the Si substrate 10 facing down:

Si substrate 10—5 cm diameter <100> wafer

$SiO_2$ mask 12—0.2 µm thick formed by thermal oxidation

Amorphous Si 18—0.8—1.0 µm thick deposited in CVD reactor at 610°C

$SiO_2$ layer 20—2 µm thick CVD deposited at 625°C

Stripes—3.5 µm wide and ⊥ to the (110) plane opened in the mask 12 by photolithographic process.

A graphite sheet 32 about 2.5 cm by 2.5 cm is interposed between the cloth heater 30 and the sample to reduce surface morphology defects induced by the weave in the cloth heater. A thermocouple 36 is embedded in the cloth heater 30. The graphite sheet 32 is coated with the insulator ($Al_2O_3$) to prevent electrical current from passing through the sheet. The heating is performed in an inert gas (Argon) environment.

The thermal cycle profile, as measured by the thermocouple 36 is shown in Figure 4a (which is a plot of the temperature in degrees Centigrade versus time in seconds.) The measured temperature is the temperature at the graphite cloth heater 30 and the actual sample temperatures may be different. Still, by maintaining this profile, repeatable results may be attained.

Excellent results have also been achieved using the two-step heater approach shown in Figures 5 and 6; in place of the single stationary heater described in connection with Figure 4. Figure 5 is a schematic diagram of the two-step heater apparatus. A device to be processed, sample 34, a portion of which is shown in the perspective Figure 6, which has been made in accordance with the previous description; is placed on a lower strip heater 30 similar to the graphite heater described in connection with Figure 4. The lower heater is energized by means (not shown) and brought to a temperature close to the melting point of silicon. Next, the upper strip heater 38, which is movable, in accordance with well known means not shown, is energized to induce melting of a strip zone 36 of silicon 18 underneath the $SiO_2$ layer 20. Next, the upper heater 38 is translated past the top surface of sample 34 to cause melting zone 36 to move in unison with the heater 38 to induce zone melting then solidification of the amorphous Si layer 18 to achieve lateral epitaxial growth transforming layer 18 into single crystal material.

For example, the lower graphite strip heater may be resistively heated to 1100—1300°C in about 20 seconds. The upper strip heater is then rapidly heated by applying power at a level of about 1 kW. Due to the additional heating of the sample 32 by radiation from this upper strip heater, in 20—40 seconds, a portion of the Si film 18 and a portion of the upper surface of the Si substrate 10 are melted in a narrow zone located below the narrow upper strip heater 38. The strip heater may then be manually moved over the sample 34 at a velocity of about 0.5 cm/sec. This rate should be slow enough for the molten zone to traverse the sample at the same rate, as determined by visual observation. When the strip heater and molten zone reach the far end of the sample, the power to both heaters is switched off.

In the apparatus of Figures 5 and 6, the strip heater is scanned in a direction parallel to the stripe openings 16. In some applications, it may be desirable to scan in a direction perpendicular to a single opening 16 and grow a continuous sheet in one direction, as shown in Figure 7; to avoid any problems associated with the intersection of two opposing growth fronts. In the apparatus of Figure 7, the sample is brought close to the melting point of Si, by a lower heater (not shown). Melting is then induced at the single stripe opening 16 by the upper heater 38 which is aligned parallel to the opening and which moves in the direction of the arrows. Melting is induced in the stripe opening 16 and then solidification and epitaxial growth of layer 18 continues in the same direction, as the heater 38 traverses the surface of sample 34.

It should be noted that the apparatus of Figure 7 results in a single continuous insulator over a substantial area underlying the single crystal and this is advantageous in the production of integrated circuits. The crystalline orientation of the growth layer 18 is determined by the orientation of the substrate 16. For example, if the substrate 16 is aligned in the (100) plane then the layer 18 will grow oriented in the (100) plane.

Figure 8 shows an external seed embodiment of the invention. In this embodiment no stripe 16 is required in insulative mask layer 12. Instead, there is a single continuous substrate 10. Since the substrate 10 is not used for seeding, it need not be a single crystal substrate but may be amorphous or polycrystalline silicon, or any suitable material for supporting a subsequent active semiconductor layer.

After the polycrystalline or amorphous Si layer 18 is formed on $SiO_2$ layer 12 by any of the many well known means, an $SiO_2$ layer 20 is formed on top of Si layer 18 to serve as a wetting agent layer, as previously described. However, at a convenient location on the surface of the top layer 20 of $SiO_2$, such as at the edge, a portion of layer 20 is removed leaving a convoluted edge 82 on the layer 20. An external seed 80 in the form of a volume of single crystal silicon is disposed on top of layer 20 so as to partly overlie the convoluted edge 82.

The sample 34 is heated up as in previous disclosed embodiments to a temperature near the melting point of silicon by a lower strip heater (not shown).

Next, the upper strip heater 38 is energized to bring the sample 34 to a temperature which will cause melting of the Si layer 18 in the zone adjacent to the heater 38. The convolutions at this edge permit the radiant energy from the heater 38 to more readily pass to the Si layer 18 beneath layer 20 thus making it easier to start melting layer 18. Next, the heater 38 is translated past the sample, in the direction of the arrows, by moving either the heater or sample with respect to one another. This causes the melted zone to move across the sample causing melting and solidification of layer 18. The layer 18 solidifies in a single crystalline state derived from external seed 80.

It should be noted that with an external seed, the necessity for the single crystal Si substrate is obviated. Accordingly, Figures 9 and 10, show alternative embodiments of an externally seeded lateral epitaxially grown structure on a insulative layer, such as $SiO_2$ layer 12′. In the Figure 9 embodiment, the wetting agent layer 20 is formed over the seed after the seed 80 has been disposed on the amorphous Si layer 18′; so the entire seed is encapsulated. In Figure 10, both the amorphous Si layer 18′ and the $SiO_2$ wetting agent layer 20 are formed over the seed 80 after the seed has been placed on the $SiO_2$ insulating substrate 12′. It is to be understood that the samples described in Figures 9 and 10 are then subjected to a heat treatment as described in connection with the previous embodiments to convert the amorphous Si layer 18′ to an epitaxial silicon layer seeded by single crystal seed 80.

In the method thus far described, only a single wetting agent layer of $SiO_2$ has been utilized. In the embodiment shown in Figure 11 an additional layer 40 of silicon nitride $Si_3N_4$ has been formed, such as by CVD, over the $SiO_2$ layer 20. In all other respects, the sample 42 is identical to the sample in Figure 2D and is heat treated in the same fashion. The added $Si_3N_4$ layer appears to further enhance the wetting properties of the composite structure as compared to a single layer of $SiO_2$. This additional $Si_3N_4$ layer may be located as shown in Figure 2D on top of the $SiO_2$ layer or it may be located below the $SiO_2$ layer adjacent the Si layer 18.

Optionally, it may be found desirable in some applications, to form the wetting agent on top of the $SiO_2$ insulating mask as shown in Figure 11a, wherein parts corresponding to those in Figure 11 are similarly numbered. Thus, there is shown in Figure 11a, silicon substrate 10 of single crystal material from which is formed an oxide insulative mask of silicon dioxide 12 and on top of silicon dioxide mask 12 is formed a layer of silicon nitride which may serve as a wetting agent during the transformation of silicon amorphous or polycrystalline silicon layer 18 to an epitaxial crystalline layer.

The silicon nitride may be formed on layer 12 by any of the well known means, such as chemical vapor deposition, sputtering, etc.

On top of amorphous or polycrystalline silicon layer 18, a first wetting agent layer of silicon dioxide is formed as in previous embodiments. The sample, as shown in Figure 11a is then subjected to a heat treatment process, as previously described, which converts the amorphous or polycrystalline silicon layer 18 to an epitaxial silicon layer in accordance with the crystalline structure of silicon substrate 10 by lateral epitaxial growth from seeded solidification.

A *recessed* $SiO_2$ lateral epitaxy by seeded solidification embodiment is shown in Figures 12A—E. This produces a planar epitaxial structure as contrasted to prior embodiments which, although shown in planar fashion, actually form slight plateaus at the stripes where the epitaxial growth is initiated. In this embodiment, a stripe of silicon nitride 52 is formed by well known means on a single crystal silicon substrate 50 as shown in Figure 12A. Next, the sample 60 is subjected to a thermal oxidation process to form a layer 54 of $SiO_2$ over the Si substrate 50 as shown in Figure 12B. Then the $Si_3N_4$ is selectively etched by ion beam or chemical etching, leaving channels 56 of exposed Si between a layer 54 of $SiO_2$, as shown in Figure 12C. Now the sample 60 is subjected to a surface etch to remove the oxide until the surface becomes flat as shown in Figure 12D. Finally, as shown in Figure 12E, an amorphous Si layer 56 is formed on the sample 60 and a cap of $SiO_2$ is formed over layer 56 to produce the planar structure shown in Figure 12E. The sample is then ready for heat treatment as previously described, to convert the amorphous Si layer 56 to epitaxy.

In addition to the advantage of the planar epitaxial structure offered by the process and apparatus of Figure 12, it should be noted that melting only has to proceed down to the top surface of $SiO_2$ layer 54 since the single crystal substrate interface is co-extensive with the top of the $SiO_2$ layer 54. This is in contrast to the Figure 2 embodiment wherein the Si substrate interface is coextensive with the bottom of $SiO_2$ layer 12. Thus, less power can be employed. Also, there may be a lesser tendency for crystal defects to occur because the growth occurs at the planar surface rather than at the recessed surface of Figure 2D.

Figure 13B shows a partial schematic of a three element semiconductor device fabricated on an $SiO_2$ substrate manufactured in accordance with the process described herein. The device of Figure 13B is a MOSFET with LOCOS oxide isolation. MOSFET stands for Metal Oxide Semiconductor Field Effect Transistor. LOCOS stands for Local Oxidation of Silicon. A MOSFET is a well known device which is made in large quantities in the United States and elsewhere.

Figure 13A illustrates how to form a MOSFET in accordance with the present invention. First a silicon substrate 80 of single crystalline silicon is oxidized forming a silicon dioxide mask 82. A layer of amorphous or polycrystalline silicon material 83 is then formed on the $SiO_2$ mask 82 and wetting agent layer 90 of $SiO_2$ is formed on first layer 83. The amorphous or polycrystalline layer 83 is then transformed by heat treatment substantially to an epitaxial layer or film 83 in accordance with the previously described embodiments. The $SiO_2$ wetting agent layer is then removed, for example, by chemical etching.

Next, as shown in Figure 13B, the active region 83 of the device is isolated from other active regions (not shown) by the LOCOS oxide 84 formed in a well known manner. A thermal oxide layer 85 is then formed on the surface of the active Si layer 83. A polysilicon gate 89 is formed by chemical vapor deposition on the oxide layer 85. This gate 89 is defined by photolithography and etching techniques. Windows are then opened on the gate oxide layer 85 for the introduction of suitable dopants by ion implantation into the source region 94 and drain region 92 of the active region 83. Finally, contacts for the source, gate and drain elements are formed by aluminum metallization.

It should be emphasized that the Figure 13B device is only one of many types of integrated circuit or semiconductor structures that could be formed using the process herein disclosed.

Referring now to Figures 14—16, a further embodiment of the invention will be described which significantly differs from the previously described embodiments in that the layer being recrystallized does not have to be in physical contact with the crystallization seed during the commencement of the application of a melting temperature. In this embodiment of the invention, the process may be generally described as follows, as shown in Figure 14.

First, a crystallization substrate is formed. This crystallization substrate may be substantially similar to the previously described single crystalline substrate of Figure 2.

Next, an insulating layer, such as $SiO_2$, is formed over the entire substrate. There is no necessity to use chemical etching to provide openings in this insulating layer, such as those provided in layer 12 of Fig. 2B previously described. After the insulating first layer is formed over the substrate, a second layer of polycrystalline or amorphous material is formed by well known means on the insulating layer. This second layer is the layer that is to be recrystallized to form an epitaxial growth in accordance with the teachings of the invention. This layer may, for example, be amorphous silicon, such as the layer 18 described in connection with Fig. 2C. A third and fourth layer is then formed over the second layer of a material preferably having a higher melting temperature than the second layer. These third and fourth layers are the wetting agent layers, previously described, and may comprise an $SiO_2$ layer followed by an $Si_3N_4$ layer. The end result is a structure such as that described previously in connection with Fig. 11, except that no openings are provided in the $SiO_2$ insulating layer 12.

The next step is to fabricate an opening through the first, second, third and fourth layers down to the substrate, preferably this may be done by mechanically scribing the sample down to the substrate. It should be noted that for ease in fabrication, mechanical scribing has been utilized for the preferred embodiment. However, the invention is not intended to be so limited and other means of forming openings, such as masking, etching, laser scribing, and other equivalents, are contemplated for use herein.

Next, the sample is subjected to a temperature which causes the second layer to melt and solidify, commencing at the opening to the substrate and laterally epitaxially growing a crystalline structure along the second layer of single crystal material.

As may be seen in Figure 15, the process apparatus is very much similar to that described in connection with Figure 5. A wafer 34, having a cross-sectional shape and construction, as shown in Figure 16, and fabricated in accordance with the method of Figure 14, is placed on a lower strip heater 30. The lower heater is energized by means (not shown) and brought to a temperature close to the melting point of the silicon.

Next, the upper strip heater 38, which is movable, in accordance with well known means (not shown), is energized to induce melting of a strip zone 36 of silicon 18 underneath the $Si_3N_4$ and $SiO_2$ layers 40 and 20, respectively.

Next, the upper heater 38 is translated past the top surface of sample 34, commencing at or before the scribed area 100 to cause melting zone 36 to move in unison with the heater 38 to induce zone melting then solidification of the amorphous silicon layer 18, thereby achieving lateral epitaxial growth and transforming layer 18 into single crystal material.

Preferably, the heater apparatus is disposed in a stainless steel chamber with ports for access. The chamber may preferably be water cooled. The bottom graphite heater 30, in a typical application, is about 17.8 cm (7 inches) long by 10.2 cm (4 inches) wide and 1.02 mm (0.04 inches) thick. The upper heater is about 11.4 cm (4.5 inches) long by 1.02 mm (0.04 inches) wide and 2.5 mm (0.1 inch) thick. The wafer may be 2.1—7.6 cm (2—3 inches) in diameter and about 0.38 mm (0.015 inches) thick and rests in a circular depression of either 5.1—7.6 cm (2 or 3 inches) diameter and about 0.25 mm (0.01 inch) deep at the center of the lower heater 30 (as shown in Figure 15). The upper heater should be located about 1 mm above the surface of wafer 34.

A computer controller motor (not shown), causes the upper heater to scan across the wafer. Both heaters are resistively heated by alternating currents of up to a few hundred amperes that are monitored and controlled by a microprocessor. Temperatures at the center and two edges of the wafer are monitored by well known thermocouples embedded in a lower heater. The silicon wafer 34, as shown in the cross-sectional view of Figure 16, are single crystal <100> wafers 10 overcoated with a thermal $SiO_2$ layer about 1 micrometers thick, as indicated by the numeral 12.

A silicon film of 0.5 micrometers thick 18 is deposited by chemical vapor deposition over the entire $SiO_2$ and Si layers.

Next, a silicon nitrate and $SiO_2$ encapsulant is deposited by well known means on the silicon layer 18. The $SiO_2$ layer is labelled 20 and the $Si_3N_4$ layer is labelled 40. After the wafer is constructed, as above, an opening down to the single crystal substrate 10 is produced, preferably by mechanically scribing the wafer as shown at 100 in Figures 15 and 16. The scribe may be either parallel to the <100> flat, as shown in Figure 16, or it may be disposed 45° with the flat along the <100> plane. The scribe has been measured to be about 5—8 micrometers deep with a cross-sectional shape, as shown in Figure 16.

The scribe opening allows the single crystal silicon substrate 10 to provide a convenient seed for the recrystallization of the amorphous silicon layer 18, as long as the zone-melting process is initiated from a surface of the wafer prior to the scribe opening. In other words, the zone-melting process should commence at or before the scribe opening 100 is reached. Then, as molten zone 36 reaches or occurs at the scribe opening 100, there is a certain amount of mass flow that moves down the scribe opening and upon solidification, the silicon substrate 10 is connected with the silicon film 18. Various geometries of scribe openings 100 have been found to be successful, including a semicircular scribe opening around the edge of the wafer, thereby allowing a larger area of the wafer to be seeded. Using this seeding technique, lateral epitaxial seeded solidification films of over 25.8 $cm^2$ (4 square inches) have been obtained with no large angle grain boundaries.

In summary, we have shown a method and apparatus for routine controllable recrystallization of Si films on $SiO_2$ coated silicon wafers of at least 7.6 cm (3 inches) in diameter.

The method and apparatus of Figures 14—16 has the advantage that the resultant structure is planar without resorting to the complex recess process described in connection with Figures 12A—E. Furthermore, if the scribing technique is used, it avoids the need for photolithography, as required in the apparatus of Figures 2A—D. Note that as with previous embodiments, it may be preferable to etch away the wetting agent layers 40 and 20 after the active Si epitaxial layer 18 has been formed, before further processing the body.

As stated earlier, the present processes and apparatus of any of the previously related embodiments is not limited to silicon. For example, gallium arsenide may be converted by this process from an amorphous or polycrystalline state to an epitaxial state. Suitable wetting agent films or layers for gallium arsenide are silicon dioxide $SiO_2$, silicon nitride $Si_3N_4$, or tungsten or molybdenum. Similarly, germanium may be converted from an amorphous or polycrystalline state to an epitaxial crystal film by the previously described process. In the germanium embodiment, a suitable wetting agent would comprise silicon nitride, molybdenum or tungsten.

Also, in addition to the previously mentioned wetting agents useful in connection with silicon, either carbon or silicon carbide may be found useful as wetting agents in connection with the conversion of silicon from polycrystalline to an epitaxial film.

In general, we have found that suitable wetting agents are those with a high enough melting point to avoid being melted during the transformation process, and which have limited interaction with the film being transformed but have sufficient enough interaction to serve as a "wetting agent" as heretofore defined.

Equivalents

There are many equivalents to the embodiments specifically described herein and such equivalents are intended to be covered by the following claims. For example, although amorphous or polycrystalline films or layers are referred to in many instances, the terms films and layers are meant to be interchangeable. Also, the seed material need not comprise the entire portion of the substrate but only the areas in contact with the films or layers being crystallized. Indeed, the seed need not be a part of the substrate, but may be formed in the film by local crystallization, such as, by local heat treatment. Additionally, the seed material need not be of identical composition with the material being crystallized. Thus, amorphous germanium may be seeded by single crystal silicon.

Furthermore, while growth has been shown as propagating laterally based on perpendicular movement of the heating source, with respect to the stripe opening, it may be advantageous in some applications to move the heating element in an oblique direction with respect to the stripe opening. The heating elements heretofore described have comprised graphite elements; however, electron beam, laser beam or other radiant sources are contemplated for use herein.

**Claims**

1. A method of forming a layered semiconductor structure on a substrate body having at least one region of single crystal material covered by an intermediate insulating layer, the method being characterised by the steps comprising:

forming a layer of amorphous or polycrystalline semiconductor material over said substrate body but separated from the said region by the intermediate layer;

after forming the semiconductor material layer, providing at least one opening in the insulating layer for exposing the semiconductor material layer to the single crystal material;

depositing another layer over the semiconductor and insulating layers, the other layer being a material operative as a wetting agent to counteract a tendency of the semiconductor material to form beads when melted;

heating, e.g. by radiant energy, at least a portion of the semiconductor layer near said opening to melt this portion and establish a mass flow of the melted portion to the said region of single crystal material and thereby establish orientation contact between the semiconductor layer and the said region; and

solidifying the melted portion of the semiconductor layer adjacent said opening to recrystallize it into large grain, substantially single crystal material seeded by the said region.

2. The method according to claim 1, wherein the at least one opening is provided so as to extend through both the semiconductor layer and the said other layer.

3. The method according to claim 1 or claim 2, wherein a substrate body is used a portion of which is a single crystal and constitutes the said region, an insulating material is deposited on the substrate as the intermediate insulating layer and the semiconductor material is deposited on the insulating layer the crystallinity of the said region of the substrate being selected to achieve a directed crystallization of the melted semiconductor material and thereby obtain a large-grain, substantially single crystal layer of a predetermined orientation.

4. The method according to claim 1, 2 or 3, wherein the material from which the said other layer is formed has a melting point higher than the semiconductor material, and the heating step is performed such as to melt the semiconductor layer but not the said other layer.

5. The method according to claim 1, 2 or 3, wherein a further layer is formed adjacent the said other layer, the further layer comprising another material operative as a wetting agent for the semiconductor material.

6. The method according to claim 5, wherein the materials from which the said other layer and the said further layer are formed have melting points higher than the semiconductor material and the heating step is performed such as to melt the semiconductor layer but not the said other and said further layers.

7. The method according to any of claims 1 to 6, wherein the substrate body itself is a single crystal.

8. The method according to any of claims 1 to 7, wherein the intermediate layer comprises $SiO_2$, the semiconductor layer is deposited Si, the said other layer is $SiO_2$ and the substrate body is single crystal Si.

9. The method according to claim 8, wherein the said other layer is removed after the solidification step.

10. The method according to claim 5 or claim 6, wherein the substrate body is Si, the semiconductor layer is Si and the said other and said further layers are selected from $SiO_2$, $Si_3N_4$, C and SiC.

11. The method according to any of claims 1 to 10, wherein a first heater is used to raise the body to a temperature slightly below the melting point of the semiconductor material layer and a second heater is translated across the surface of the body commencing at an area prior to the opening to bring a zone of material in the semiconductor layer to its melting point and translating such melted zone along this layer to effect lateral epitaxial growth of the semiconductor material by seeded solidification from the said single crystal region.

12. A method according to any preceding claim, wherein the opening is formed through all the layers laid on the substrate, e.g. by scribing through the said layers.

13. A method of forming a semiconductor body, wherein amorphous or polycrystalline semiconductor material in contact with an insulating layer is transformed to large grain, substantially single crystal semiconductor material, characterised in that:

an external seeding means is employed in operative contact with the semiconductor material to be transformed,

a layer of the amorphous or polycrystalline semiconductor material is formed over the insulating layer,

a layer of a wetting agent material is formed over the insulating and semiconductor layers to prevent agglomeration of the semiconductor material when melted;

thereafter at least a portion of the semiconductor layer is heated to melt the portion thereof and establish an orientation contact of the melted portion with the seeding means; and

the melted portion of the semiconductor layer is solidified and transformed to create large grain, substantially single crystal material, which transformed material has a crystal orientation predetermined by the crystal orientation of the seeding means.

**Patentansprüche**

1. Verfahren zum Bilden eines Halbleiterschichtaufbaus auf einem Substratkörper mit zumindest einer Region eines Einkristallmaterials, das von einer Isolierzwischenschicht bedeckt ist, wobei das Verfahren durch die Schritte gekennzeichnet ist, daß

eine Schicht eines amorphen oder polykristallinen Halbleitermaterials über dem Substratkörper, jedoch von der genannten Region durch die Zwischenschicht getrennt gebildet wird;

nach der Bildung der Halbleitermaterialschicht zumindest eine Öffnung in der Isolierschicht zur Freilegung der Halbleitermaterialschicht gegenüber dem Einkristallmaterial vorgesehen wird;

eine weitere Schicht über der Halbleiter- und der Isolierschicht aufgebracht wird, wobei die weitere Schicht ein Material ist, das als Benetzungsmittel zum Gegenwirken gegen eine Tendenz des Halbleitermaterials zur Bildung von Kügelchen beeim Schmelzen wirksam ist;

zumindest ein Bereich der Halbleiterschicht nahe der genannten Öffnung, z.B durch Strahlungsenergie, erwärmt wird, um diesen Bereich zu schmelzen und einen Massefluß des geschmolzenen Bereichs zu der genannten Region des Einkristallmaterials herzustellen und dadurch einen Orientierungskontakt zwischen der Halbleiterschicht und der genannten Region herbeizuführen; und

der geschmolzene Bereich der Halbleiterschicht an der Öffnung verfestigt wird, um sie zu großkörnigem, im wesentlichen aus Einkristall bestehendem Material, das von der genannten Region geimpft worden ist, zu rekristallisieren.

2. Verfahren nach Anspruch 1, bei dem die zumindest eine Öffnung so vorgesehen ist, daß sie sich sowohl durch die Halbleiterschicht als auch durch die weitere Schicht erstreckt.

3. Verfahren nach Anspruch 1 oder Anspruch 2, bei dem ein Substratkörper verwendet wird, don dem ein Bereich ein Einkristall ist und die genannte Region darstellt ein Isoliermaterial auf das Substrat als die Isolierzwischenschicht aufgebracht und das Halbleitermaterial auf der Isolierschicht aufgebracht wird, wobei die Kristallinität der genannten Region des Substrats so gewählt wird, daß eine gerichtete Kristallisation des geschmolzenen Halbleitermaterials erzielt und dadurch eine großkörnige, im wesentlichen aus Einkristall bestehende Schicht einer vorbestimmten Orientierung erreicht wird.

4. Verfahren nach Anspruch 1, 2 oder 3, bei dem das Material, aus dem die weitere Schicht gebildet wird, einen höheren Schmelzpunkt als das Halbleitermaterial besitzt und der Erwärmungsschritt in der Weise durchgeführt wird, daß die Halbleiterschicht, jedoch nicht die weitere Schicht, geschmolzen wird.

5. Verfahren nach Anspruch 1, 2 oder 3, bei dem eine zusätzliche Schicht angrenzend an die genannte weitere Schicht gebildet wird, wobei die zusätzliche Schicht aus einem weiteren Material besteht, das als Benetzungsmittel für das Halbleitermaterial wirksam ist.

6. Verfahren nach Anspruch 5, bei dem die Materialien, aus denen die weitere Schicht und die suzätzliche Schicht gebildet werden, höhere Schmelzpunkte als das Halbleitermaterial besitzen und der Erwärmungsschritt in der Weise durchgeführt wird, daß die Halbleiterschicht jedoch nicht die weitere und die zusätzliche Schicht, geschmolzen wird.

7. Verfahren nach einem der Ansprüche 1 bis 6, bei dem der Substratkörper selbst ein Einkristall ist.

8. Verfahren nach einem der Ansprüche 1 bis 7, bei dem die Zwischenschicht aus $SiO_2$ besteht, die Halbleiterschicht niedergeschlagenes Si, die weitere Schicht $SiO_2$ und der Subtratkörper Einkristall-Si ist.

9. Verfahren nach Anspruch 8, bei dem die weitere Schicht nach dem Verfestigungsschritt entfernt wird.

10. Verfahren nach Anspruch 5 oder Anspruch 6, bei dem der Substratkörper Si, die Halbleiterschicht Si ist und die weitere und die zusätzliche Schicht aus $SiO_2$, $Si_3N_4$, C und SiC ausgewählt werden.

11. Verfahren nach einem der Ansprüche 1 bis 10, bei dem eine erste Heizvorrichtung zum Erwärmen des Körpers auf eine Temperatur geringfügig unter dem Schmelzpunkt der Halbleitermaterialschicht verwendet und eine zweite Heizvorrichtung über die Oberfläche des Körpers in einem Gebiet vor der Öffnung beginnend verlagert wird, um eine Materialzone in der Halbleiterschicht auf ihren Schmelzpunkt zu bringen und eine derartige geschmolzene Zone entlang dieser Schicht zur Herbeiführung eines lateralen epitaxialen Wachstums des Halbleitermaterials durch geimpfte Verfestigung von der Einkristallregion zu verlagern.

12. Verfahren nach einem der vorhergehenden Ansprüche, bei dem die Öffnung durch sämtliche auf das Substrat abgelegte Schichten hindurch, z.B. durch Hindurchritzen durch die Schichten, gebildet wird.

13. Verfahren zum Bilden eines Halbleiterkörpers, bei dem ein amorphes oder polykristallines Halbleitermaterial in Kontakt mit einer Isolierschicht in großkörniges, im wesentlichen aus Einkristall bestehendes Halbleitermaterial umgewandelt wird, dadurch gekennzeichnet, daß

ein äußeres Impfungsmittel in Wirkkontakt mit dem umzuwandelnden Halbleitermaterial verwendet wird,

eine Schicht des amorphen oder polykristallinen Halbleitermaterials über der Isolierschicht gebildet wird,

eine Schicht eines Benetzungsmittelmaterials über der Isolier- und der Halbleiterschicht zur Verhinderung einer Agglomeration des Halbleitermaterials beim Schmelzen gebildet wird;

danach zumindest ein Bereich der Halbleiterschicht erwärmt wird, um deren Bereich zu schmelzen und einen Orientierungskontakt des geschmolzenen Bereichs mit dem Impfungsmittel herzustellen; und

der geschmolzene Bereich der Halbleiterschicht verfestigt und umgewandelt wird, um ein großkörniges, im wesentlichen aus Einkristall bestehendes Material zu erzeugen, welches umgewandelte Material eine von der Kristallorientierung des Impfungsmittels vorbestimmte Kristallorientierung besitzt.

## Revendications

1. Procédé de formation d'une structure à semiconducteur revêtant un corps de substrat comportant au moins une région d'un matériau monocristallin recouverte d'une couche isolante intermédiaire, caractérisé en ce qu'il comprend les étapes consistant à former une couche de matériau semi-conducteur amorphe ou polycristallin par dessus le corps du substrat, cette couche étant séparée de ladite région au moyen de la couche intermédiaire, à prévoir, après avoir formé la couche de matériau semi-conducteur, au moins une ouverture dans la couche isolante afin d'exposer la couche de matériau semi-conducteur au matériau monocristallin, à déposer une autre couche par dessus les couches de matériau semiconducteur et isolante, cette autre couche étant en un matériau agissant en tant qu'agent de mouillage afin de contrebalancer une tendance du matériau semi-conducteur à former des gouttes ou perle une fois fondu, à chauffer, par exemple au moyen d'une énergie de rayonnement, au moins une portion de la couche de matériau semi-conducteur au voisinage de ladite ouverture afin de faire fondre cette portion et d'établir un flux massique de la portion fondue en direction de ladite région du matériau monocristallin et d'établir ainsi un contact à orientation entre la couche de matériau semi-conducteur et ladite région, et à solidifier la portion fondue de la couche de matériau semi-conducteur qui est adjacente à ladite ouverture, afin de la faire recristalliser sous la forme d'un matériau à gros grain, sensiblement monocristallin, ensemencé par ladite région.

2. Procédé suivant la revendication 1, caractérisé en ce que l'ouverture est prévue de manière à s'étendre à la fois à travers la couche de matériau semi-conducteur et à travers l'autre couche.

3. Procédé suivant l'une quelconque des revendications 1 ou 2 caractérisé en ce qu'on utilise un corps de substrat dont une portion est monocristalline et constitue ladite région, on dépose sur le substrat un matériau isolant en tant que couche isolante intermédiaire et on dépose la matériau semi-conducteur sur la couche isolante, la cristallinité de ladite région du substrat étant choisie de manière à obtenir une cristallisation orientée du matériau semi-conducteur fondu et par conséquent une couche à gros grain, sensiblement monocristalline, ayant une orientation prédéterminée.

4. Procédé suivant l'une quelconque des revendications 1, 2 ou 3 caractérisé en ce que le matériau dont est formée l'autre couche, a un point de fusion supérieur à celui du matériau semi-conducteur et l'étape de chauffage est exécutée de façon à fondre la couche de matériau semi-conducteur mais non pas l'autre couche.

5. Procédé suivant l'une quelconque des revendications 1, 2 ou 3, caractérisé en ce qu'on forme une couche additionnelle adjacente à l'autre couche, cette couche additionnelle comprenant un autre matériau agissant en tant qu'agent de mouillage pour le matériau semi-conducteur.

6. Procédé suivant la revendication 5 caractérisé en ce que les matériaux dont sont formées l'autre couche et la couche additionnelle, ont des points de fusion supérieurs à celui du matériau semi-conducteur et l'étape de chauffage est exécutée de manière à faire fondre la couche de matériau semi-conducteur et non pas l'autre couche et la couche additionnelle.

7. Procédé suivant l'une quelconque des revendications 1 à 6 caractérisé en ce que le corps du substrat lui même est monocristallin.

8. Procédé suivant l'une quelconque des revendications 1 à 7 caractérisé en ce que la couche intermédiaire est en silice, la couche de matériau semi-conducteur est constitué par du silicium déposé, l'autre couche est en silice et le corps du substrat est du silicium monocristallin.

9. Procédé suivant la revendication 8 caractérisé en ce que l'autre couche est enlevée après l'étape, de solidification.

10. Procédé suivant l'une quelconque des revendications 5 ou 6 caractérisé en ce que le corps du substrat est en silicium, la couche de matériau semi-conducteur est en silicium et l'autre couche et la couche additionnelle sont choisies parmi $SiO_2$, $Si_3N_4$, C et SiC.

11. Procédé suivant l'une quelconque des revendications 1 à 10 caractérisé en ce qu'on utilise un premier élément chauffant afin d'élever le corps à une température légèrement inférieure au point de fusion de la couche de matériau semi-conducteur et on déplace un second élément chauffant en travers de la surface du corps, en commençant un une zone située avant l'ouverture, afin d'amener une zone de matériau dans la couche de matériau semi-conducteur à atteindre son point de fusion, et en déplaçant une telle zone fondue le long de cette couche afin de provoquer une croissance épitaxiale latérale du matériau semi-conducteur par une solidification par germes à partir de la région monocristalline.

12. Procédé suivant l'une quelconque des revendications précédentes caractérisé en ce que l'ouverture est formée à travers toutes les couches déposées sur le substrat, par exemple en gravant ces couches.

13. Procédé de formation d'un corps semi-conducteur dans lequel on transforme un matériau semi-conducteur amorphe ou polycristallin, en contact avec une couche isolante, en un matériau semi-conducteur à gros grain, sensiblement monocristallin, caractérisé en ce qu'on emploie un moyen d'ensemencement externe en contact actif avec la matériau semi-conducteur devant être transformé, on forme une couche de matériau semi-conducteur amorphe ou polycristallin par dessus la couche isolante, on forme une couche d'un matériau d'agent de mouillage par dessus les couches de matériau semi-conducteur et isolante, afin d'empêcher l'agglomération du matériau semi-conducteur une fois celui-ci fondu, on chauffe ensuite au moins une portion de la couche de matériau semi-conducteur afin de faire fondre cette portion et d'établir un contact à orientation de la portion fondue avec les moyens d'ensemencement et on solidifie et transforme la portion fondue de la couche de matériau semi-conducteur afin de créer un matériau à gros grain, sensiblement monocristallin, ce matériau transformé ayant une orientation cristalline qui est prédéterminée par l'orientation cristalline du matériau d'encemenssement.

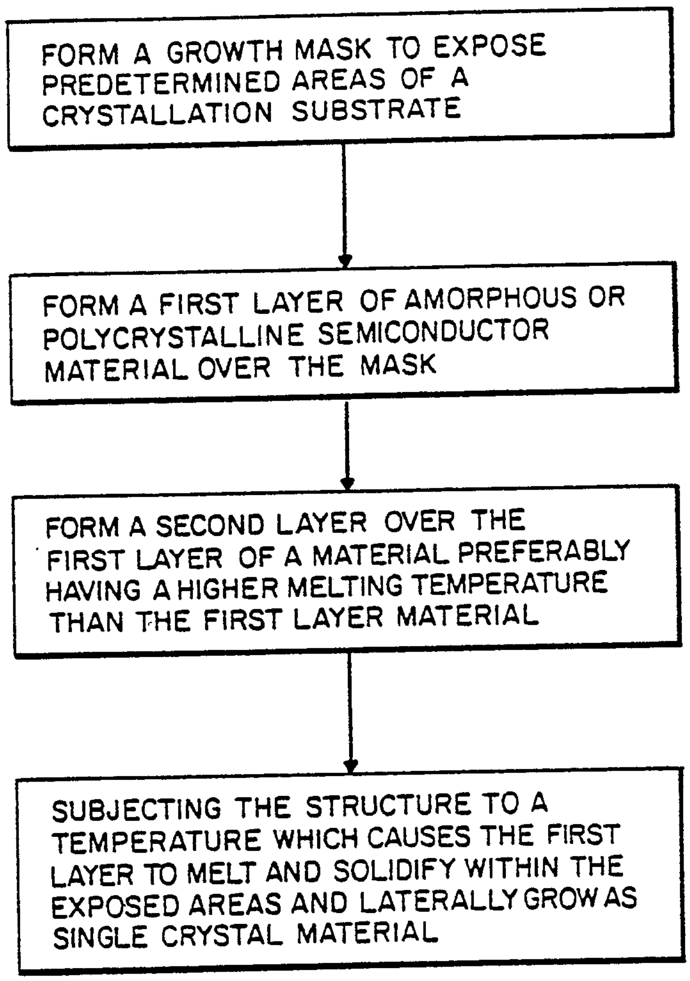
FORM A GROWTH MASK TO EXPOSE PREDETERMINED AREAS OF A CRYSTALLATION SUBSTRATE
FORM A FIRST LAYER OF AMORPHOUS OR POLYCRYSTALLINE SEMICONDUCTOR MATERIAL OVER THE MASK
FORM A SECOND LAYER OVER THE FIRST LAYER OF A MATERIAL PREFERABLY HAVING A HIGHER MELTING TEMPERATURE THAN THE FIRST LAYER MATERIAL
SUBJECTING THE STRUCTURE TO A TEMPERATURE WHICH CAUSES THE FIRST LAYER TO MELT AND SOLIDIFY WITHIN THE EXPOSED AREAS AND LATERALLY GROW AS SINGLE CRYSTAL MATERIAL

FIG. 1

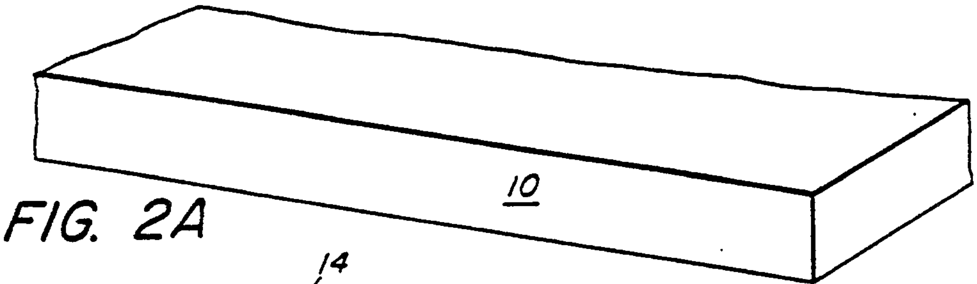


FIG. 2A

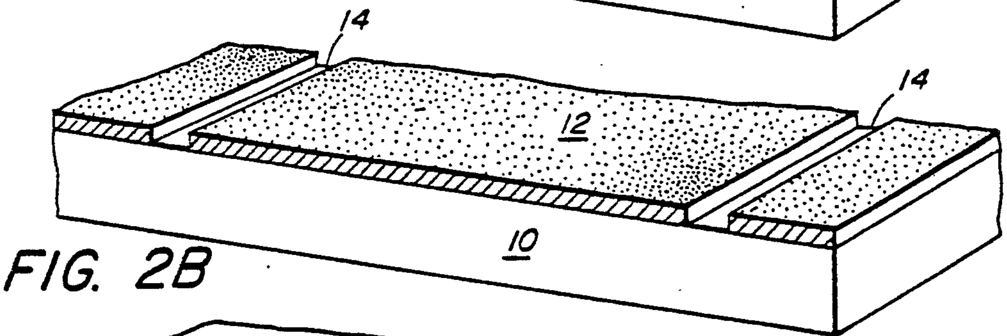


FIG. 2B

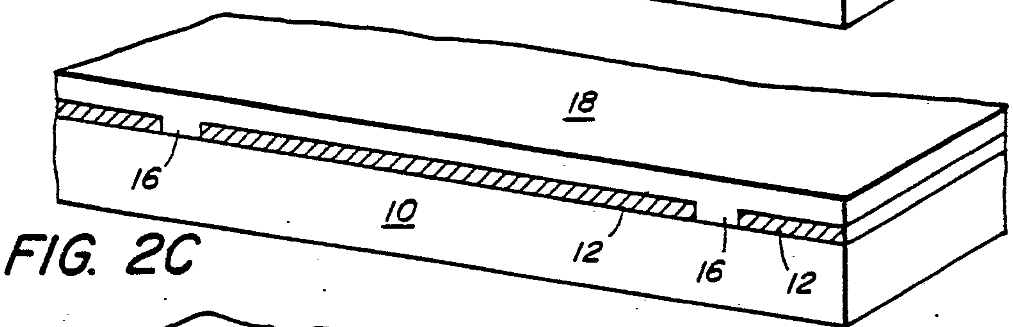


FIG. 2C

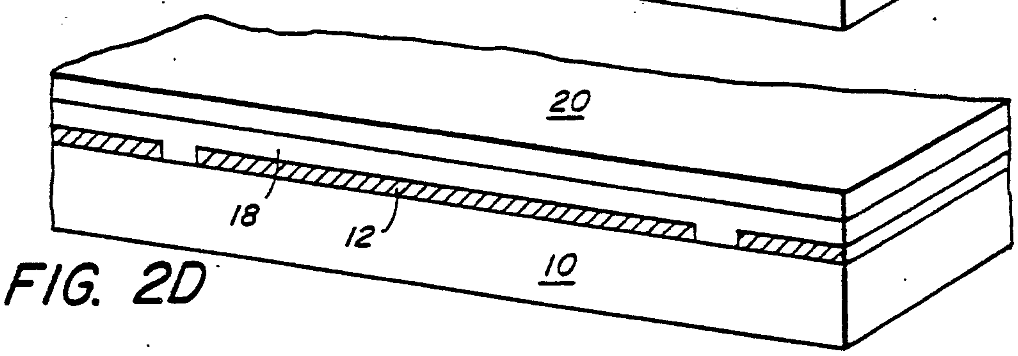


FIG. 2D

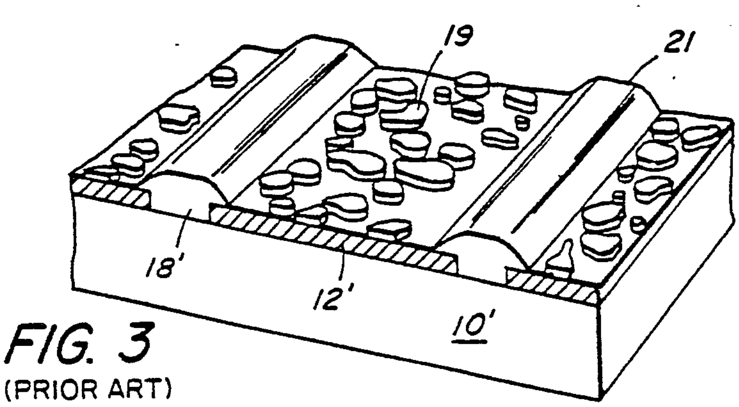


FIG. 3
(PRIOR ART)

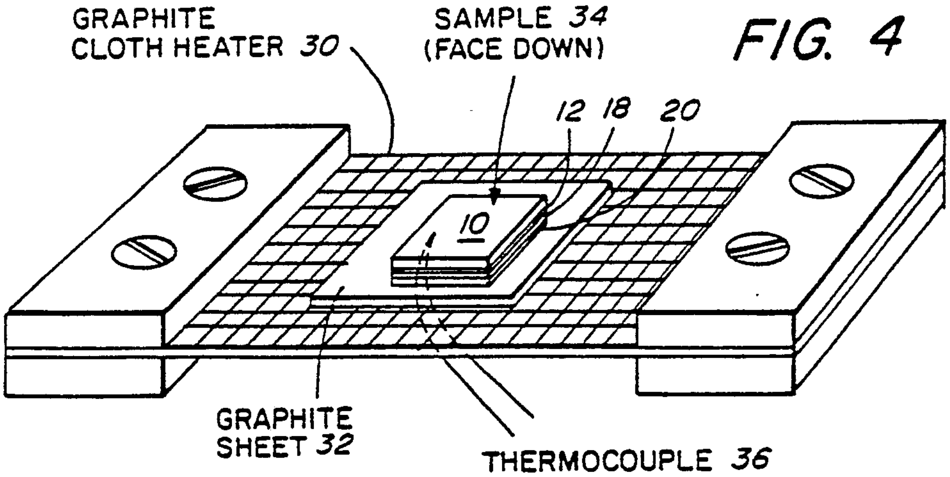


FIG. 4

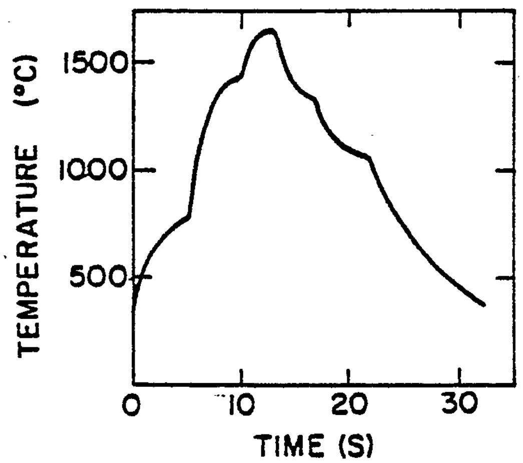


FIG. 4a

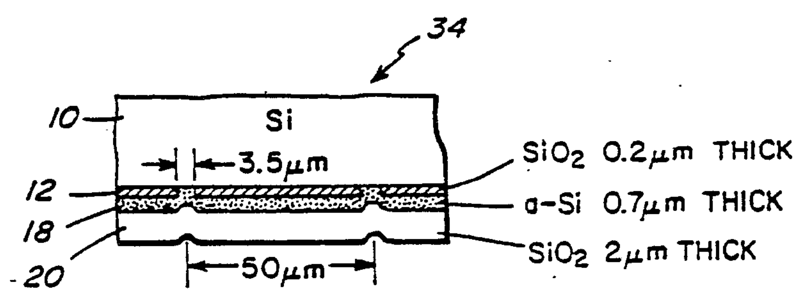


FIG. 4b

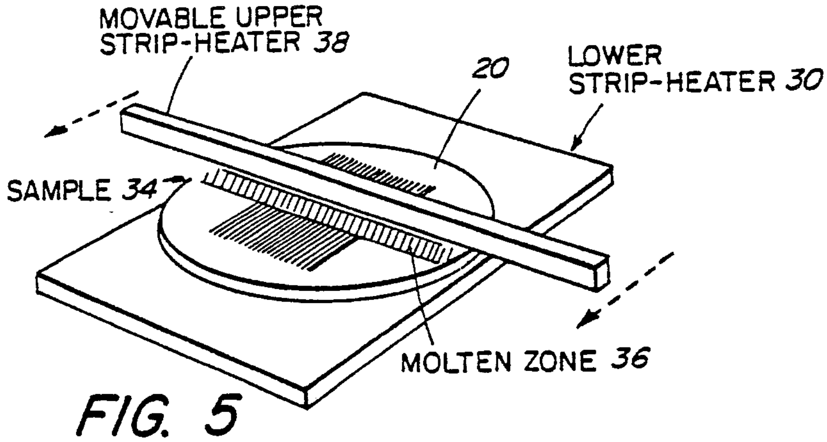


FIG. 5

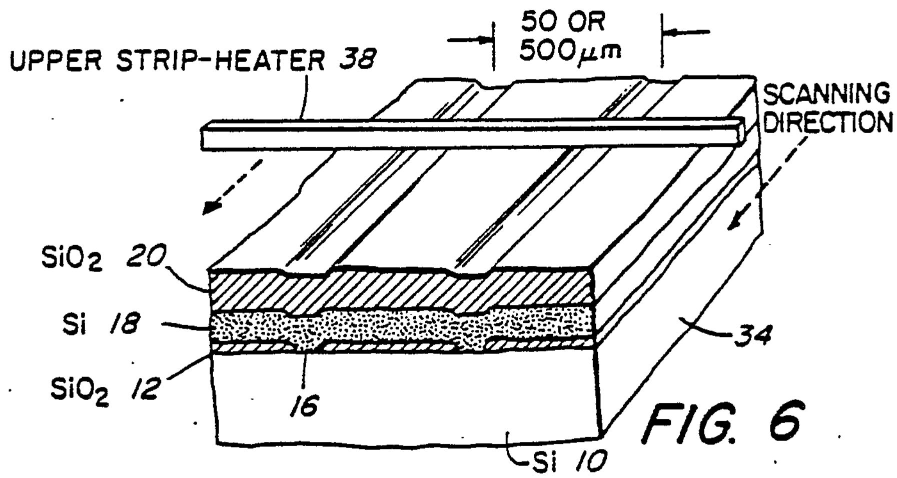


FIG. 6

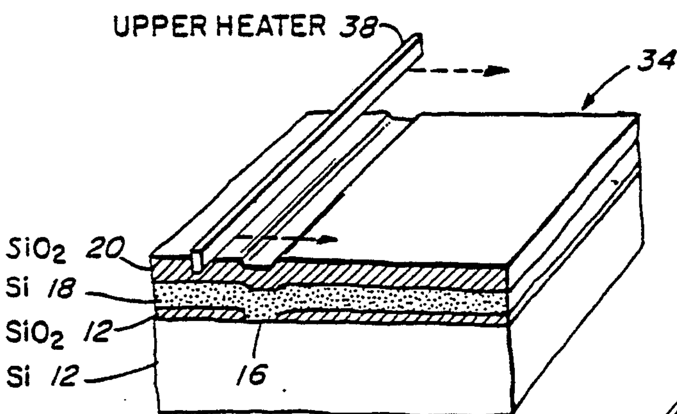


FIG. 7

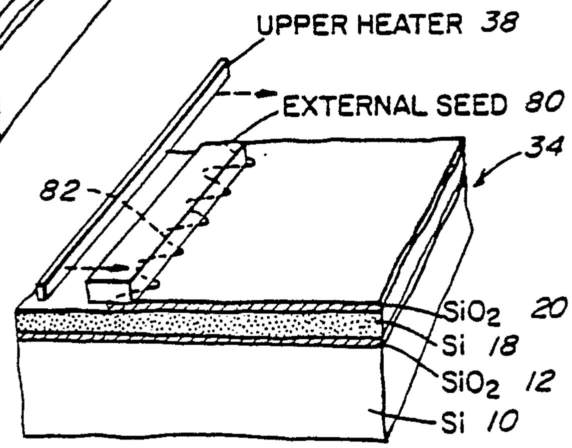


FIG. 8

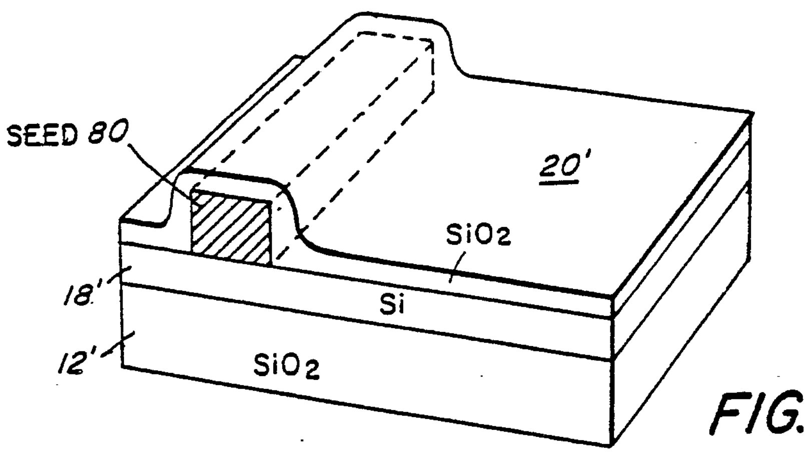


FIG. 9

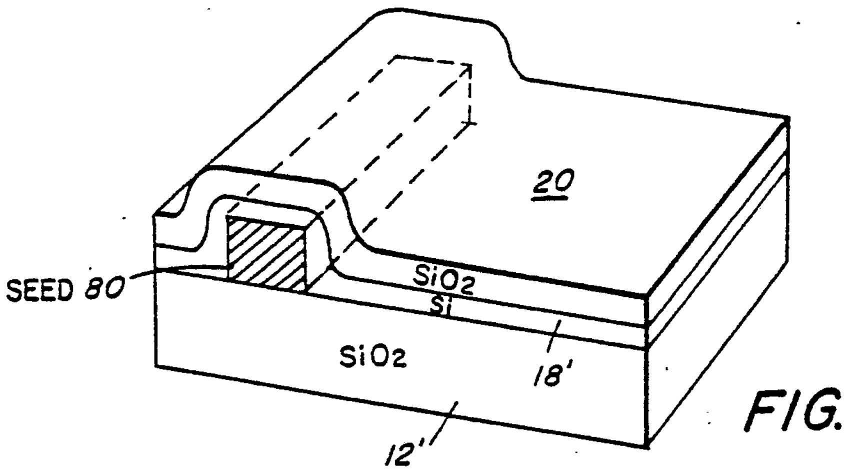


FIG. 10

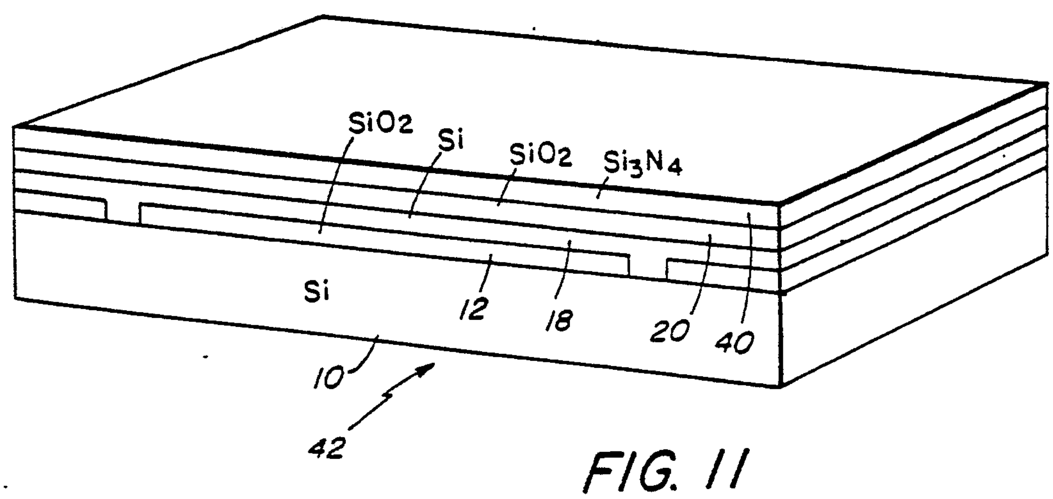


FIG. 11

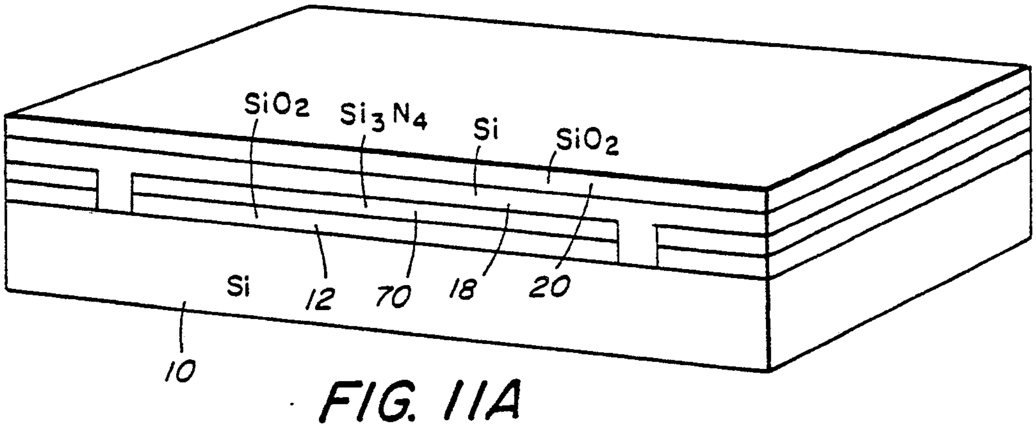


FIG. 11A

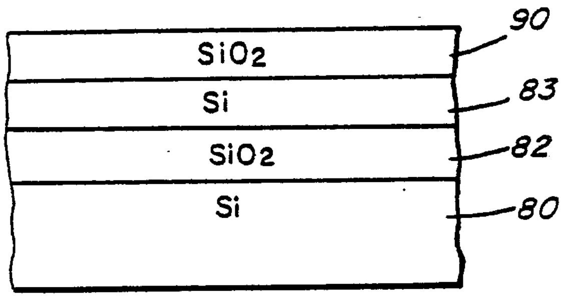


FIG. 13A

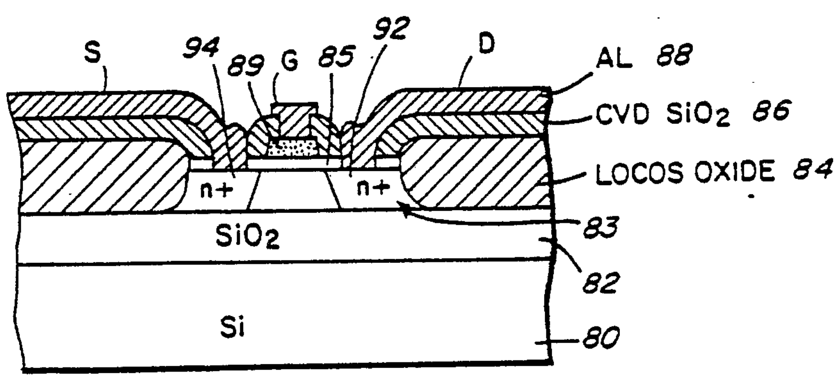


FIG. 13B

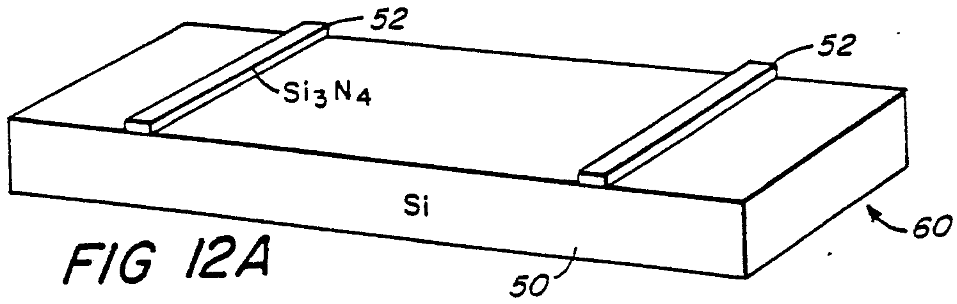

FIG 12A

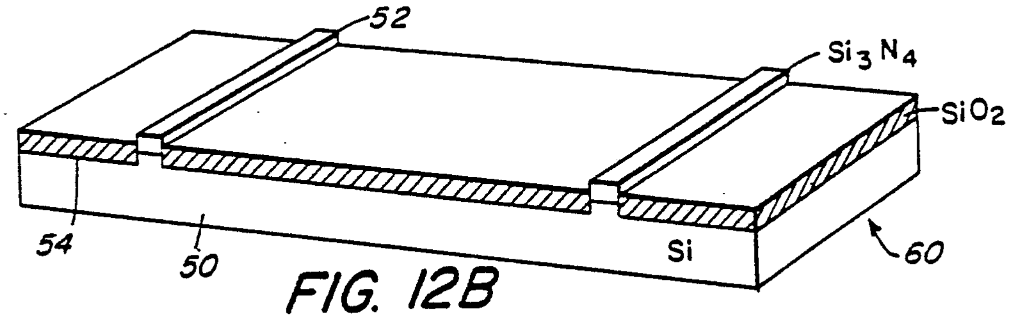

FIG. 12B

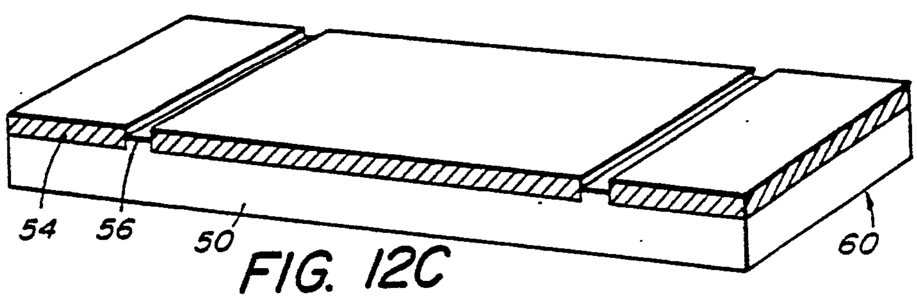

FIG. 12C

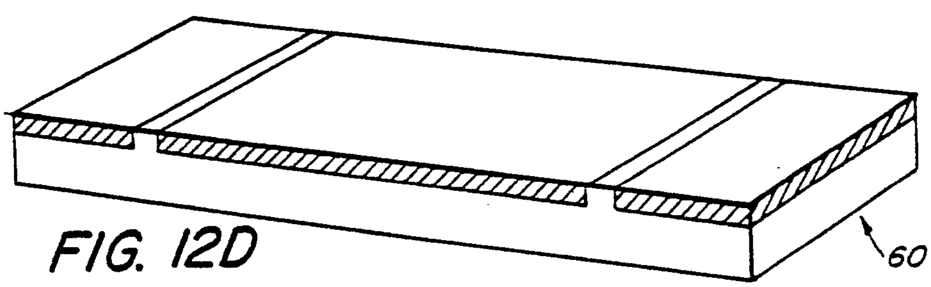

FIG. 12D

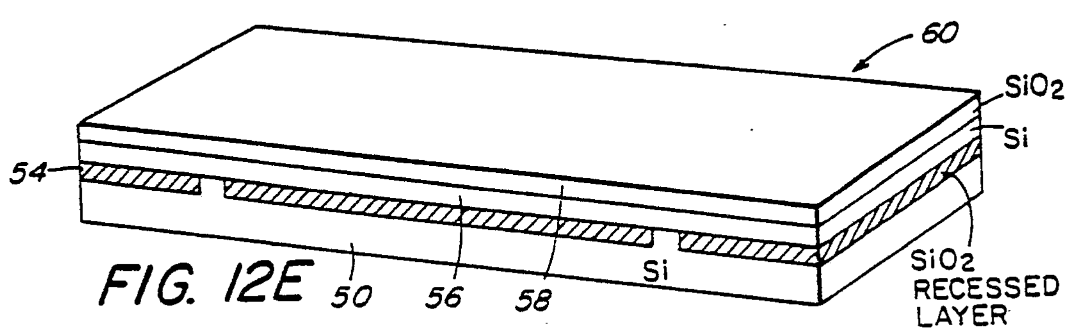

FIG. 12E

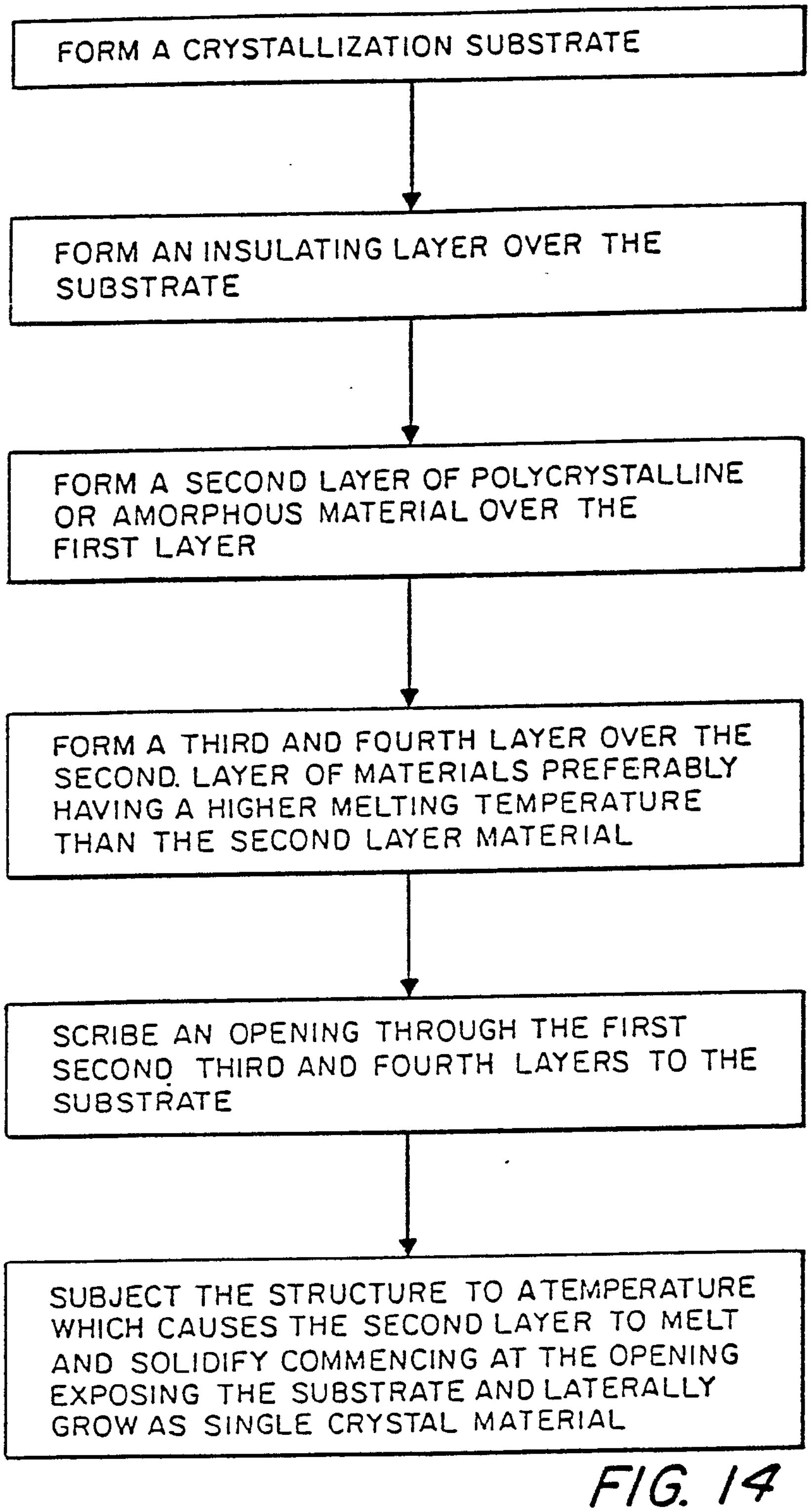
FORM A CRYSTALLIZATION SUBSTRATE
FORM AN INSULATING LAYER OVER THE SUBSTRATE
FORM A SECOND LAYER OF POLYCRYSTALLINE OR AMORPHOUS MATERIAL OVER THE FIRST LAYER
FORM A THIRD AND FOURTH LAYER OVER THE SECOND. LAYER OF MATERIALS PREFERABLY HAVING A HIGHER MELTING TEMPERATURE THAN THE SECOND LAYER MATERIAL
SCRIBE AN OPENING THROUGH THE FIRST SECOND THIRD AND FOURTH LAYERS TO THE SUBSTRATE
SUBJECT THE STRUCTURE TO A TEMPERATURE WHICH CAUSES THE SECOND LAYER TO MELT AND SOLIDIFY COMMENCING AT THE OPENING EXPOSING THE SUBSTRATE AND LATERALLY GROW AS SINGLE CRYSTAL MATERIAL

FIG. 14

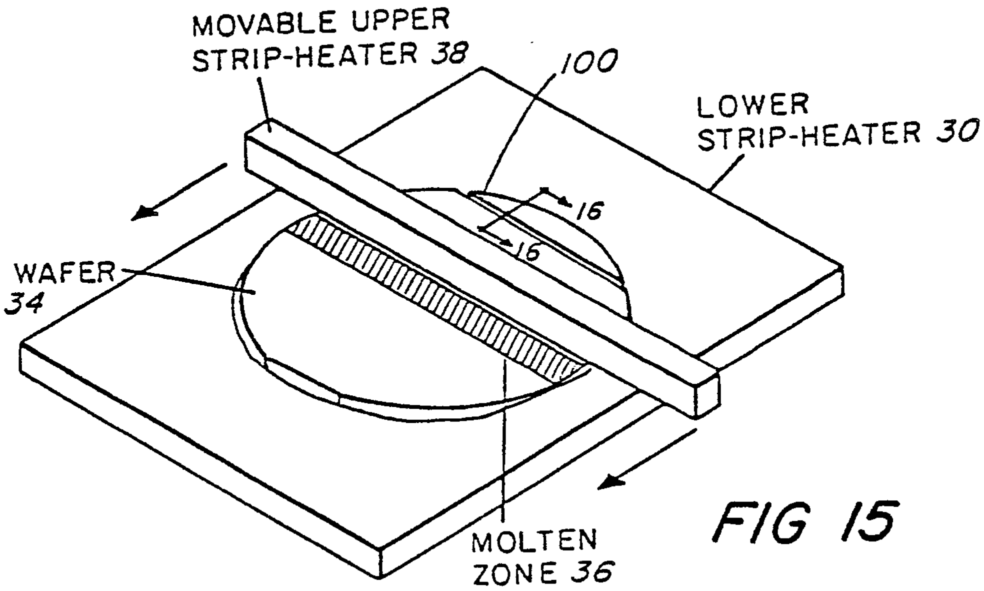
MOVABLE UPPER
STRIP-HEATER 38
100
LOWER
STRIP-HEATER 30
16
16
WAFER
34
MOLTEN
ZONE 36

FIG 15

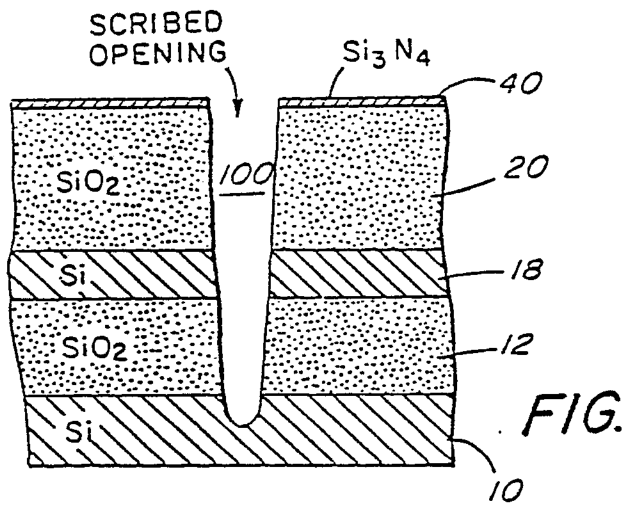
SCRIBED
OPENING
$Si_3N_4$
40
$SiO_2$
100
20
Si
18
$SiO_2$
12
Si
10

FIG. 16